## Europäisches Patentamt
## European Patent Office
## Office européen des brevets

(19)

(11) Veröffentlichungsnummer : **0 099 003**
**B1**

(12)

# EUROPÄISCHE PATENTSCHRIFT

(45) Veröffentlichungstag der Patentschrift :
12.11.86

(21) Anmeldenummer : 83106103.1

(22) Anmeldetag : 22.06.83

(51) Int. Cl.⁴ : **G 03 F 7/26**

(54) Entwickler und Verfahren zum Entwickeln für bestrahlte negativ-arbeitende Reproduktionsschichten.

(30) Priorität : 15.07.82 US 398509

(43) Veröffentlichungstag der Anmeldung :
25.01.84 Patentblatt 84/04

(45) Bekanntmachung des Hinweises auf die Patenterteilung : 12.11.86 Patentblatt 86/46

(84) Benannte Vertragsstaaten :
DE FR GB NL

(56) Entgegenhaltungen :
DE-A- 2 504 130

(73) Patentinhaber : AMERICAN HOECHST CORPORATION
Route 202-206 North
Somerville, N.J. 08876 (US)

(72) Erfinder : Walls, John E.
46, Center Street
Annandale New Jersey 08801 (US)

(74) Vertreter : Euler, Kurt Emil, Dr. et al
KALLE Niederlassung der Hoechst AG Rheingaustrasse 190 Postfach 3540
D-6200 Wiesbaden 1 (DE)

**Beschreibung**

Die Erfindung betrifft einen Entwickler, der zum Entwickeln von negativ-arbeitenden bestrahlten (belichteten) Reproduktionsschichten geeignet ist, die auch ein organisches Bindemittel enthalten können.

Strahlungs(licht)empfindliche Reproduktionsschichten werden beispielsweise bei der Herstellung von Offsetdruckformen oder von Photoresists (beides im weiteren Kopiermaterialien genannt) verwendet, d. h. sie werden im allgemeinen vom Verbraucher oder vom industriellen Hersteller auf einen Schichtträger aufgebracht. Als Schichtträger in diesen Kopiermaterialien werden Metalle wie Zink, Magnesium, Chrom, Kupfer, Messing, Stahl, Silicium, Aluminium oder Kombinationen dieser Metalle, Kunststoffolien, Papier oder ähnliche Materialien eingesetzt. Diese Schichtträger können ohne eine modifizierende Vorbehandlung, bevorzugt aber nach Durchführung einer Oberflächenmodifizierung wie einer mechanischen, chemischen und/oder elektrochemischen Aufrauhung, einer Oxidation und/oder einer Behandlung mit Hydrophilierungsmitteln (z. B. bei Trägern für Offsetdruckplatten) mit der strahlungsempfindlichen Reproduktionsschicht beschichtet werden. Die üblichen Reproduktionsschichten enthalten neben mindestens einer strahlungsempfindlichen Verbindung meist noch ein organisches Bindemittel (Harze o. ä.) und gegebenenfalls auch noch Weichmacher, Pigmente, Farbstoffe, Netzmittel, Sensibilisatoren, Haftvermittler, Indikatoren und andere übliche Hilfsmittel. Die Reproduktionsschichten werden nach ihrer Belichtung entwickelt, um aus ihnen ein Bild zu erzeugen, beispielsweise wird so eine Druckform oder ein Photoresist erhalten.

Ein Entwickler für negativ-arbeitende Reproduktionsschichten muß die nicht von elektromagnetischer Strahlung (z. B. Licht) getroffenen Schichtteile (die späteren Nichtbildstellen) aus der belichteten Schicht herauslösen können, ohne dabei die von der Strahlung getroffenen Teile (die späteren Bildstellen) der Schicht wesentlich zu beeinflussen. In der als ein repräsentatives Beispiel zu nennenden DE-A 2 065 732 (= US-A 3 867 147) werden als geeignete Entwickler beispielsweise aufgeführt : Wasser, Wasser/organische Lösemittel-Gemische, wäßrige Salzlösungen, wäßrige Säurelösungen, wäßrig-alkalische Lösungen und unverdünnte organische Lösemittel, denen gegebenenfalls Tenside und/oder Hydrophilierungsmittel zugesetzt werden können. Die in den dortigen Beispielen hauptsächlich eingesetzten Entwickler enthalten Wasser, Na-laurylsulfat, Na-sulfat, Weinsäure und gegebenenfalls Benzylalkohol ; andere Entwickler enthalten oder bestehen aus Isopropanol, n-Propanol, n-Propylacetat, Polyacrylsäure, 1,1,1-Trichlorethan, Aceton oder Ethylenglykolmonomethylether. Die am besten wirksamen Entwickler für solche negativarbeitenden Reproduktionsschichten enthalten aber bisher in der Regel bestimmte Tenside, so daß insbesondere bei einer maschinellen Entwicklung ein Aufschäumen des Entwicklers auftritt.

Neben den bereits erwähnten Entwicklerkomponenten sind auch noch folgende aus dem Stand der Technik bekanntgeworden :

In der DE-C 1 200 133 (= US-A 3 110 596) werden alkalische Entwicklerlösungen beschrieben, die Salze von Fluorwasserstoffsäuren, von Säuren des Si, des Ti, des Sn und/oder B enthalten und einen pH-Wert von 7 bis 12 aufweisen. Als konkrete Salze werden u. a. aufgeführt $Na_3PO_4$, $Na_2SiO_3$, $K_3PO_4$ oder $NaBF_4$.

Das Entwicklungsverfahren gemäß der DE-A 2 504 130 wird bei 35 bis 80 °C mit Entwicklern verschiedenster Zusammensetzungen durchgeführt, beispielsweise können diese (unter einer Vielzahl von aufgeführten Verbindungen) auch Natrium- oder Kaliumborat, Natrium- oder Kaliumsilicat, Di- oder Trinatriumphosphat in einer Menge von 0,1 bis 20 Gew.-% als alkalische Verbindung enthalten. Als Tenside können in einem Anteil von bis zu 10 Gew.-% Salze von aliphatischen Carbonsäuren, von Schwefelsäureestern von Fettalkoholen oder von aromatischen Sulfonsäuren vorhanden sein, außerdem in einem Anteil von 0,1 bis 5 Gew.-% u. a. auch Oxalsäure oder eines ihrer Salze als Mittel zur Verhinderung der Schaumbildung.

In der DE-A 3 036 077 werden als für Diazoniumsalzpolykondensate und bestimmte Bindemittel (Polymere mit seitenständigen Alkenylsulfonyl- oder Cycloalkenylsulfonylurethangruppen) enthaltende Reproduktionsschichten geeignete Entwickler wäßrig-alkalische Lösungen mit einem pH-Wert von 8 bis 14 (vorzugsweise 10 bis 13) genannt, die Puffersalze wie Alkaliphosphate, -silikate, -borate, -carbonate, - acetate oder -benzoate enthalten können. Als mögliche weitere Bestandteile werden anionische Netzmittel (z. B. Natriumlaurylsulfat) und wasserlösliche Polymere genannt.

Die wäßrig-alkalische Entwicklerlösung nach der US-A 4 314 022 weist einen pH-Wert von 12,5 bis 13,7 auf und enthält ein Alkalihydroxid und einen Komplexbildner für $Al^{3+}$-Ionen wie Oxalsäure, Nitrilotriessigsäure oder Salycilsäure.

In der prioritätsälteren, nicht-vorveröffentlichten EP-A 0 076 984 wird ein wäßrig-alkalischer Entwickler für negativ-arbeitende Reproduktionsschichten beschrieben, der 5 bis 60 Gew.-% eines Salzes einer aromatischen Carbonsäure enthält, deren Substituenten unmittelbar der Carboxylgruppe benachbart sind und eine Aminogruppe, eine Hydroxygruppe und/oder Chlor oder Brom darstellen. Als weitere Komponenten kann der Entwickler auch anionische Tenside wie Schwefelsäuremonoalkylester (Alkyl von $C_7$ bis $C_{14}$), Komplexbildner wie Phosphate oder Basen wie Alkalihydroxide oder Phosphate enthalten.

Die bekannten Entwickler sind zwar für manche Anwendungen geeignet und lassen sich beispielsweise auch bei einer Küvettenentwicklung oftmals praxisgerecht einsetzen, sie weisen jedoch bei einigen der bekannten negativ-arbeitenden Reproduktionsschichten Schwierigkeiten auf ; dies gilt insbesondere bei ihrem Einsatz in den heute sehr verbreiteten Entwicklungsmaschinen, in denen beispielsweise Schaum- und/oder Korrosionsprobleme auftreten können. Auch zeigen einige der Entwickler Lagerprobleme, da sie bei tieferen Temperaturen beispielsweise zu Ausfällungen neigen, die sich nicht ohne weiteres beim Erwärmen wieder auflösen und damit als Wirkungskomponente wegfallen. Auch ist die Entwicklungsgeschwindigkeit der bekannten Entwickler bei einigen negativ-arbeitenden Reproduktionsschichten nicht immer befriedigend, dies gilt insbesondere für solche, die ein organisches Bindemittel enthalten.

Aufgabe der vorliegenden Erfindung ist es, einen wäßrigen Entwickler für negativ-arbeitende Reproduktionsschichten vorzuschlagen, der keine Zusätze von organischen Lösemitteln benötigt, auch für organische Bindemittel enthaltende Schichten geeignet ist und möglichst nicht die übrigen, vorher dargestellten Nachteile aufweist.

Die Erfindung geht aus von einem wäßrig-alkalischen Entwickler für bestrahlte strahlungsempfindliche negativarbeitende, gegebenenfalls ein organisches Bindemittel enthaltende Reproduktionsschichten auf der Basis von Wasser, einem anionischen Tensid, mindestens einem alkalisch-reagierenden anorganischen Salz und mindestens einer aliphatischen Dicarbonsäure oder einem ihrer Salze. Der erfindungsgemäße Entwickler ist dann dadurch gekennzeichnet, daß der Entwickler bei einem pH-Wert von 8 bis 12

a) 0,05 bis 10 Gew.-% eines Natrium-, Kalium- oder Lithiumsalzes des Schwefelsäureesters eines Alkanols von $C_7$ bis $C_{14}$,

b) 0,001 bis 5 Gew.-% eines Natrium-, Kalium- oder Ammoniummetasilikats,

c) 0,1 bis 15 Gew.-% eines Natrium-, Kalium-, Lithium- oder Ammoniumborats,

d) 0,01 bis 5 Gew.-% einer Alkandisäure von $C_2$ bis $C_6$ oder eines ihrer Natrium-, Kalium- oder Ammoniumsalze, und

e) 0,5 bis 12 Gew.-% eines Di- oder Trinatrium- oder -Kaliumphosphats enthält und das Gewichtsverhältnis der Natrium- zu den Kaliumionen im Entwickler im Bereich von 1 zu 1 bis 1,4 zu 1 liegt.

Eine weitere Lösung der gestellten Aufgabe ist ein Verfahren zum Entwickeln von negativ-arbeitenden Reproduktionsschichten, bei dem die bestrahlte, gegebenenfalls ein organisches Bindemittel enthaltende Reproduktionsschicht mit einem Entwickler mit den angegebenen Komponenten behandelt wird. Dabei werden die nicht von der Strahlung getroffenen Stellen der Reproduktionsschicht (z. B. die beim späteren Drucken benötigten Nichtbildstellen) in der Regel durch Auflösen entfernt.

Der Entwickler ist eine Lösung auf wäßriger Basis mit alkalischem pH-Wert im Bereich von 8 bis 12, insbesondere von 9 bis 11 und bevorzugt von 9,5 bis 10,5. Der Entwickler enthält als anionisches Tensid insbesondere ein Natrium-, Kalium- oder Lithiumsalz des Schwefelsäureesters eines Octanols, Decanols oder Dodecanols, vorzugsweise das Natriumsalz des Schwefelsäureesters eines Octanols oder Decanols. Diese Tenside ergeben eine auch bei niedrigen Temperaturen stabile Lösung. Die Konzentration des Tensids liegt im Bereich von 0,05 bis 10 Gew.-%, insbesondere von 0,5 bis 6 Gew.-% und bevorzugt von 1 bis 4 Gew.-%. Ferner enthält die Lösung ein Metasilikat, von dem angenommen wird, daß es korrosionshemmende Wirkung hat, es wird in einem Anteil von 0,001 bis 5 Gew.-%, insbesondere von 0,005 bis 0,5 Gew.-% und vorzugsweise von 0,01 bis 0,1 Gew.-% zugesetzt. In der Lösung ist außerdem ein Borat enthalten, vorzugsweise ein Tetra- oder Pentaborat. Es wird vermutet, daß das Borat die korrosionshemmende Wirkung des Silikats unterstützt und außerdem das die Nichtbildstellen bildende Aluminium bzw. Aluminiumoxid bei Druckplatten konserviert ; es ist in einem Anteil von 0,1 bis 15 Gew.-%, insbesondere von 0,5 bis 8 Gew.-% und bevorzugt von 1 bis 4 Gew.-% anwesend. Als weiteren Bestandteil enthält die Lösung als aliphatische Dicarbonsäure (Alkandisäure) beispielsweise Oxal-, Malon-, Bernstein-, Glutar- oder Adipinsäure oder deren Salze (beispielsweise die Lithium-, Kalium-, Natrium- oder Ammoniumsalze), wobei Kaliumoxalat bevorzugt wird. Dieser Bestandteil ist in einem Anteil von 0,01 bis 5 Gew.-%, insbesondere von 0,1 bis 4 Gew.-% und vorzugsweise von 0,5 bis 3 Gew.-% anwesend. Schließlich enthält die Lösung noch ein Di- oder Trikalium- oder -natriumphosphat, insbesondere ein Dinatriumhydrogenphosphat oder Trinatriumphosphat, das sich in einem Anteil von 0,5 bis 12 Gew.-%, insbesondere von 0,75 bis 6 Gew.-% und vorzugsweise von 1 bis 4 Gew.-% in der Lösung befindet.

Es besteht ein bestimmtes Gewichtsverhältnis zwischen den Natrium- und Kaliumionen in der Lösung. Ein äußerst vorteilhaftes Gleichgewicht zwischen Entwicklungsgeschwindigkeit und Lagerbeständigkeit ist gegeben, wenn dieses im Bereich von 1,0 bis 1,4 : 1, insbesondere bei 1,1 bis 1,3 : 1 und vorzugsweise bei 1,15 bis 1,25 : 1 liegt. Mit dem erfindungsgemäßen Entwickler wird u. a. die Lagerfähigkeit bei Temperaturen unter 10 °C verbessert, weil eine Niederschlagsbildung zumindest wesentlich reduziert wird.

Unter den Angaben der Salzbegriffe in den Komponenten c) und e) kann auch verstanden werden, daß diese nicht unmittelbar in dem Entwickler eingesetzt werden, sondern auch, daß diese erst in der Entwicklerlösung aus der entsprechenden Säure- und Basenkomponente hergestellt werden können ; d. h. beispielsweise, daß $Na_3PO_4$ auch aus $H_3PO_4$ und NaOH erst im Entwickler erzeugt werden kann.

Die erfindungsgemäßen Entwickler sind dazu geeignet, auch polymere organische Bindemittel enthaltende negativ-arbeitende Reproduktionsschichten sauber aufzuentwickeln, ohne daß es zu einem

3

Angriff oder einer Unterwanderung der Bildstellen kommt. Außerdem treten keine größeren Umweltprobleme, z. B. durch destillative Aufarbeitung von organischen Lösemittelanteilen auf, und die erfindungsgemäßen Entwickler lassen sich zumindest ohne größeres Schaumauftreten auch in automatischen Verarbeitungsmaschinen einsetzen.

Die zu entwickelnde Reproduktionsschicht liegt insbesondere als Teil (strahlungsempfindliche Schicht) einer Offsetdruckplatte oder als auf ein Trägermaterial aufgebrachter Resist (Photoresistschicht) vor. Als Trägermaterialien kommen beispielsweise solche auf der Basis von Zink, Chrom, Magnesium, Kupfer, Messing, Stahl, Silicium, Aluminium oder Kombinationen dieser Metalle in Frage oder auch Kunststoffolien, Papier oder damit vergleichbare Materialien. Diese können ohne eine spezielle modifizierende Vorbehandlung mit einer geeigneten Reproduktionsschicht versehen werden, bevorzugt wird diese Beschichtung jedoch erst nach einer Oberflächenmodifizierung wie einer mechanischen, chemischen oder elektrochemischen Aufrauhung, einer Oxidation und/oder einer Behandlung mit Hydrophilierungsmitteln (insbesondere bei Trägern für Offsetdruckplatten) durchgeführt. Zu den besonders geeigneten Substraten zur Herstellung von Offsetdruckplatten zählen solche aus Aluminium oder einer seiner Legierungen.

Die in der Praxis sehr häufig anzutreffenden Aluminiumträgermaterialien für Druckplatten werden im allgemeinen vor Aufbringen der lichtempfindlichen Schicht noch mechanisch (z. B. durch Bürsten und/oder mit Schleifmittel-Behandlungen), chemisch (z. B. durch Ätzmittel) und/oder elektrochemisch (z. B. durch Wechselstrombehandlung in wäßrigen HCl- oder $HNO_3$-Lösungen) aufgerauht.

Nach dem bevorzugt angewendeten elektrochemischen Aufrauhverfahren schließt sich dann in einer weiteren, gegebenenfalls anzuwendenden Verfahrensstufe eine anodische Oxidation des Aluminiums an, um beispielsweise die Abriebs- und Haftungseigenschaften der Oberfläche des Trägermaterials zu verbessern. Zur anodischen Oxidation können die üblichen Elektrolyte wie $H_2SO_4$, $H_3PO_4$, $H_2C_2O_4$, Amidosulfonsäure, Sulfobernsteinsäure, Sulfosalicylsäure oder deren Mischungen eingesetzt werden.

Der Stufe einer anodischen Oxidation des Druckplatten-Trägermaterials aus Aluminium können auch eine oder mehrere Nachbehandlungsstufen nachgestellt werden. Dabei wird unter Nachbehandeln insbesondere eine hydrophilierende chemische oder elektrochemische Behandlung der Aluminiumoxidschicht verstanden, beispielsweise eine Tauchbehandlung des Materials in einer wäßrigen Polyvinylphosphonsäure-Lösung nach der DE-C 1 621 478 (= GB-A 1 230 447), eine Tauchbehandlung in einer wäßrigen Alkalisilikat-Lösung nach der DE-B 1 471 707 (= US-A 3 181 461) oder eine elektrochemische Behandlung (Anodisierung) in einer wäßrigen Alkalisilikat-Lösung nach der DE-A 2 532 769 (= US-A 3 902 976). Diese Nachbehandlungsstufen dienen insbesondere dazu, die bereits für viele Anwendungsgebiete ausreichende Hydrophilie der Aluminiumoxidschicht noch zusätzlich zu steigern, wobei die übrigen bekannten Eigenschaften dieser Schicht mindestens erhalten bleiben.

Als negativ-arbeitende lichtempfindliche Reproduktionsschichten sind grundsätzlich alle Schichten geeignet, die nach dem Belichten, mit einer nachfolgenden Entwicklung und gegebenenfalls Fixierung eine bildmäßige Fläche liefern, von der gedruckt werden kann und/oder die ein Reliefbild einer Vorlage darstellt. Sie werden entweder beim Hersteller von vorsensibilisierten Druckplatten oder von sogenannten Trockenresists oder direkt vom Verbraucher auf eines der üblichen Trägermaterialien aufgebracht. Außer den lichtempfindlichen Substanzen können diese Schichten selbstverständlich noch andere Bestandteile wie z. B. Harze, Farbstoffe oder Weichmacher enthalten. Insbesondere kommen als strahlungsempfindliche Verbindungen solche in Betracht, die in der eingangs bereits zitierten EP-A 0 076 984 beschrieben werden.

## Beispiel 1

Es wird ein Entwickler mit folgenden Bestandteilen hergestellt, wobei die Komponenten in wasserfreier Form berechnet sind :

91,73 Gew.-% $H_2O$
2,50 Gew.-% Natriumsalz des Schwefelsäureesters des Octanols
0,07 Gew.-% Na-metasilikat
1,50 Gew.-% Dinatriumphosphat ($Na_2HPO_4$)
1,50 Gew.-% Trinatriumphosphat ($Na_3PO_4$)
1,70 Gew.-% K-oxalat
1,00 Gew.-% K-tetraborat

Der Entwickler hat einen Feststoffgehalt von 8,27 % und einen pH-Wert von 10,3. Bei Korrosionstests an Aluminium, die über einen Zeitraum von 300 h geführt werden, wird eine Gewichtszunahme von 0,002 % festgestellt. Bei einer Temperatur von 1 °C ist weder eine Niederschlagsnoch eine Kristallbildung zu beobachten. Man kann die Lösung einfrieren und dann auf Raumtemperatur zurückkehren lassen. Bei Raumtemperatur erhält man eine klare, keine unlöslichen Stoffe enthaltende Lösung.

Eine elektrochemisch aufgerauhte und anodisch oxidierte Aluminiumplatte wird mit einer negativarbeitenden lichtempfindlichen Beschichtung mit einem Gehalt an einem Polykondensationsprodukt aus 1 Mol 3-Methoxy-diphenyl-amin-4-diazoniumsulfat und 1 Mol 4,4'-Bis-methoxy-methyl-diphenylether, einem Umsetzungsprodukt aus einem Polyvinylbutyral mit Propenylsulfonylisocyanat, $H_3PO_4$, einem blauen Farbstoff und Ethylenglykolmonomethylether versehen, diese Schicht getrocknet und unter einer Negativ-Testvorlage belichtet. Die Platte wird durch Tauchen und leichtes Bewegen während 60 sec in der oben angegebenen Lösung entwickelt. Ein 21-stufiger Stauffer-Stufenkeil, der ein Teil der Testvorlage war, wird auf der Platte mit Druckfarbe eingefärbt und ergibt 7 vollständig und 3 teilweise gedeckte Keilstufen. Das ist ein Ergebnis, wie man es von einem praxisgerechten Entwickler erwartet.

Eine weitere Testplatte wird ebenso entwickelt und nach dem Abspülen noch mit einem konservierenden Film aus dem gleichen Entwickler überzogen. Nach einwöchiger Lagerung wird mit dieser Platte ein Freilaufversuch auf der Druckmaschine durchgeführt und dabei mit einer Platte verglichen, die mit dem gleichen Entwickler entwickelt, jedoch mit einer normalen, im wesentlichen aus Tapiokadextrin als filmbildender Substanz bestehenden Lösung konserviert wurde. Beide Platten haben ein gleichartiges Freilaufverhalten, ohne Anzeichen von Blindlaufen oder Tonen auf den Testplatten.

### Vergleichsbeispiel V1

Ein wäßrig-alkalischer Entwickler gemäß der EP-A 0 076 984 mit einem Gesamtfeststoffgehalt von 23 % (mit u. a. einem Gehalt an Natriumphosphat), davon 12 % Natriumsalicylat, wird nach den Angaben des Beispiels 1 getestet. Beim Korrosionstest wird ein Gewichtsverlust von 5,1 % gemessen. Bei Abkühlung auf 10 °C beginnt die Lösung bereits einen Niederschlag zu bilden, der erst bei Raumtemperatur und unter Rühren wieder in Lösung geht. Eine entwickelte Platte erscheint erst nach vergleichsweise langer Behandlungszeit als entwickelt. Nach dem Einfärben ermittelt man 7 vollgedeckte und 7 teilgedeckte Keilstufen.

### Vergleichsbeispiel V2

Ein wäßrig-alkalischer Entwickler gemäß der DE-A 30 36 077 mit einem Gesamtfeststoffgehalt von 16 % (mit u. a. einem Gehalt an Natriumlaurylsulfat, Natriummetasilikat und Natriumphosphat) wird nach den Angaben des Beispiels 1 getestet. Beim Korrosionstest werden 17,2 % des Aluminiums weggelöst. Die mit diesem Entwickler behandelte Platte hat nicht vollständig entwickelte Nichtbildstellen. Sie ergibt 9 vollgedeckte und 8 teilgedeckte Keilstufen.

### Beispiele 2 bis 4 und Vergleichsbeispiele V3 bis V9

Die folgenden Beispiele und Vergleichsbeispiele werden mit veränderten Zusammensetzungen von Entwicklern durchgeführt (siehe Tabelle Seite 6 f.).

### Vergleichsbeispiel V3

Im Unterschied zu Beispiel 1 wird bei diesem Vergleichsbeispiel das Kaliumoxalat weggelassen. Der pH-Wert der Lösung beträgt 10,27, und bei niedrigen Temperaturen kommt es zu keinem Niederschlag. Eine Platte wird belichtet und entwickelt, nach dem Einfärben erscheint der Hintergrund ausentwickelt, der Stufenkeil zeigt jedoch 8 vollgedeckte und 5 teilgedeckte Stufen. Ein derartiges Ergebnis ist für die Praxis wenig geeignet und zeigt die Nützlichkeit der Oxalationen.

### Vergleichsbeispiel V4

Abweichend von Beispiel 1 wird hier das Kaliumtetraborat weggelassen, der pH-Wert der Lösung ist 10,29. Eine belichtete Platte wird entwickelt und ergibt nach dem Einfärben 7 vollgedeckte und 5 teilgedeckte Keilstufen. Nach dem Korrosionstest sind 3,47 % des Aluminiums weggelöst, da das Silikat allein die Korrosion nicht verhindern kann. Daraus wird ersichtlich, daß das Tetraborat zur Entwicklung und Korrosionsverhinderung beiträgt.

### Vergleichsbeispiel V5

In diesem Vergleich wird im Gegensatz zu Beispiel 1 das Natriumsilikat weggelassen, der pH-Wert der Lösung beträgt 10,18. Eine belichtete Platte wird entwickelt und bringt nach dem Einfärben gleiche Ergebnisse wie bei Anwesenheit von Silikat. Der Korrosionstest zeigt, daß wegen der fortdauernden Ablagerung von Salzen eine Gewichtszunahme des Aluminiums um 3,7 % stattgefunden hat. Dieses Beispiel beweist eindeutig, daß sowohl Silikat als auch Tetraborat anwesend sein müssen, wenn die Nettoveränderung bei Gewichtszunahme bzw. -verlust im wesentlichten Null ergeben soll.

### Vergleichsbeispiel V6

In diesem Vergleich wird der nach dem Molverhältnis gleichwertige Anteil an Di- und Trikaliumphosphat genommen, wie er in Beispiel 1 für die entsprechenden Natriumsalze verwendet wird. Die

Tabelle

| Entwickler-komponenten (in Gew.-%) | Beispiele bzw. Vergleichsbeispiele | | | | | | | | | |
|---|---|---|---|---|---|---|---|---|---|---|
| | V3 | V4 | V5 | V6 | V7 | 2 | 3 | 4 | V8 | V9 |
| Wasser | 93,43 | 92,73 | 93,80 | 90,94 | 91,91 | 90,16 | 91,73 | 91,44 | 90,23 | 92,48 |
| $Na_2HPO_4$ | 1,50 | 1,50 | 1,50 | | 1,50 | | 1,50 | 1,50 | 3,00 | 0,75 |
| $Na_3PO_4$ | 1,50 | 1,50 | 1,50 | | 1,50 | | 1,50 | 1,50 | 1,50 | 1,50 |
| $K_2HPO_4$ | | | | 1,85 | | | | | | |
| $K_3PO_4$ | | | | 1,94 | | | | | | |
| $Na_2SiO_3$ | 0,07 | 0,07 | | 0,07 | 0,07 | 0,07 | 0,07 | 0,07 | 0,07 | 0,07 |
| $Na_2B_4O_7$ | | | | | 1,00 | | | | | |
| $K_2B_4O_7$ | 1,00 | | 1,00 | 1,00 | | 1,00 | 1,00 | 1,00 | 1,00 | 1,00 |
| KOH | | | | | | 1,14 | | | | |
| NaOH | | | | | | 1,94 | | | | |
| $Na_2C_2O_4$ (Natrium-oxalat) | | | | | 1,52 | | | | | |
| $K_2C_2O_4$ (Kaliumoxalat) | | 1,70 | 1,70 | 1,70 | | | 1,70 | | 1,70 | 1,70 |
| Na-Salz des Schwefel-säureesters des Octanols | 2,50 | 2,50 | 2,50 | 2,50 | 2,50 | 2,50 | | 2,50 | 2,50 | 2,50 |
| dto. des Decanols | | | | | | | 2,50 | | | |
| $H_2C_2O_4$ (Oxalsäure) | | | | | | 0,92 | | | | |
| $K_2C_4H_4O_4$ (Kalium-succinat) | | | | | | | | 1,99 | | |
| $H_3PO_4$ (85%ig, wäßrig) | | | | | | 2,27 | | | | |

Entwicklungsergebnisse entsprechen denen des Beispiels 1, mit der Ausnahme, daß der Entwickler bei 8 °C zu einer festen Masse kristallisiert. In diesem Fall beträgt das Gewichtsverhältnis der Natrium- zu den Kaliumionen 0,17 : 1.

## Vergleichsbeispiel V7

In diesem Vergleich wird der nach dem Molverhältnis gleichwertige Anteil an Natriumoxalat anstelle von Kaliumoxalat genommen. Eine entwickelte Platte wird mit dem erfindungsgemäßen Entwickler behandelt und dann eingefärbt. Auf dem Stufenkeil entstehen 7 vollgedeckte und 4 teilgedeckte Stufen. Bei 1 °C kommt es weder zu einer Kristallisation noch zu einer sonstigen Niederschlagsbildung. In diesem Beispiel beträgt das Gewichtsverhältnis der Natrium- zu den Kaliumionen 1 : 0, und es zeigt sich, daß der Entwickler etwas von seinem Entwickelvermögen einbüßt, obwohl kein Niederschlag zu beobachten ist.

## Beispiel 2

In diesem Beispiel wird eine Alternativausführung vorgestellt, in der anstelle bestimmter Salze die Säuren und Hydroxide verwendet werden. Bei der Prüfung erweist sich dieser Entwickler als im wesentlichen identisch mit dem Entwickler aus Beispiel 1.

## Beispiel 3

Es wird ein Entwickler entsprechend Beispiel 1 hergestellt, wobei allerdings das Natriumsalz des Schwefelsäureesters des Decanols anstelle des Esters des Octanols verwendet wird. Dieser Entwickler bringt in jeder Hinsicht eine weitgehend gleiche Leistung ; bei 8 °C können sich jedoch unter Umständen Kristalle ausbilden, die sich jedoch ohne Rühren durch bloßes Erwärmen auf Raumtemperatur wieder auflösen lassen.

## Beispiel 4

In diesem Beispiel wird im Unterschied zu Beispiel 1 der stöchiometrisch gleichwertige Anteil an Kaliumsuccinat anstelle des Oxalats genommen. Die Ergebnisse entsprechen in jeder Hinsicht weitgehend den Ergebnissen, die man mit dem Kaliumoxalat enthaltenden Entwickler erzielt.

## Vergleichsbeispiel V8

Dieser Vergleich verwendet die doppelte Menge an Dinatriumhydrogenphosphat, der pH-Wert beträgt hier 11,9. Das nach dem Entwickeln entstehende Bild ist stark angegriffen, und einige Spitzlichtbereiche sind völlig entfernt. Das Gewichtsverhältnis der Natrium- zu den Kaliumionen beträgt 1,49 : 1.

## Vergleichsbeispiel V9

Dieser Vergleich verwendet die halbe Menge an Dinatriumhydrogenphosphat, so daß der pH-Wert auf 8,6 gesenkt wird. Mit diesem Entwickler läßt sich zwar eine Platte entwickeln, der Entwicklungsprozeß dauert jedoch sehr lange. Das entstehende Bild ist in den Grauzonen nicht vollständig ausentwickelt. Das Gewichtsverhältnis der Natrium- zu den Kaliumionen beträgt 0,86 : 1.

## Patentansprüche

1. Wäßrig-alkalischer Entwickler für bestrahlte strahlungsempfindliche negativ-arbeitende, gegebenenfalls ein organisches Bindemittel enthaltende Reproduktionsschichten auf der Basis von Wasser, einem anionischen Tensid, mindestens einem alkalisch-reagierenden anorganischen Salz und mindestens einer aliphatischen Dicarbonsäure oder einem ihrer Salze, dadurch gekennzeichnet, daß der Entwickler bei einem pH-Wert von 8 bis 12

a) 0,05 bis 10 Gew.-% eines Natrium-, Kalium- oder Lithiumsalzes des Schwefelsäureesters eines Alkanols von $C_7$ bis $C_{14}$,

b) 0,001 bis 5 Gew.-% eines Natrium-, Kalium- oder Ammoniummetasilikats,

c) 0,1 bis 15 Gew.-% eines Natrium-, Kalium-, Lithium- oder Ammoniumborats,

d) 0,01 bis 5 Gew.-% einer Alkandisäure von $C_2$ bis $C_6$ oder eines ihrer Natrium-, Kalium- oder Ammoniumsalze und

e) 0,5 bis 12 Gew.-% eines Di- oder Trinatrium- oder -kaliumphosphats enthält und das Gewichtsverhältnis der Natrium- zu den Kaliumionen im Entwickler im Bereich von 1 zu 1 bis 1,4 zu 1 liegt.

2. Entwickler nach Anspruch 1, dadurch gekennzeichnet, daß der Entwickler a) ein Natriumsalz des Schwefelsäureesters eines Octanols oder Decanols, b) Natriummetasilikat, c) Kaliumtetraborat, d) Kaliumoxalat und e) Dinatrium- oder Trinatriumphosphat enthält.

3. Verfahren zum Entwickeln von negativ-arbeitenden Reproduktionsschichten, bei dem die bestrahlte, gegebenenfalls ein organisches Bindemittel enthaltende Reproduktionsschicht mit einem wäßrig-alkalischen Entwickler auf der Basis von Wasser, einem anionischen Tensid, mindestens einem alkalisch-reagierenden anorganischen Salz und mindestens einer aliphatischen Dicarbonsäure oder einem ihrer Salze behandelt wird, dadurch gekennzeichnet, daß der Entwickler bei einem pH-Wert von 8 bis 12

a) 0,05 bis 10 Gew.-% eines Natrium-, Kalium- oder Lithiumsalzes des Schwefelsäureesters eines Alkanols von $C_7$ bis $C_{14}$,

b) 0,001 bis 5 Gew.-% eines Natrium-, Kalium- oder Ammoniummetasilikats,

c) 0,1 bis 15 Gew.-% eines Natrium-, Kalium-, Lithium- oder Ammoniumborats,

d) 0,01 bis 5 Gew.-% einer Alkandisäure von $C_2$ bis $C_6$ oder eines ihrer Natrium-, Kalium- oder Ammoniumsalze, und

e) 0,5 bis 12 Gew.-% eines Di- oder Trinatrium- oder -kaliumphosphats enthält und das Gewichtsverhältnis der Natrium- zu den Kaliumionen im Entwickler im Bereich von 1 zu 1 bis 1,4 zu 1 liegt.


## Claims

1. Aqueous-alkaline developer composition for irradiatied radiation-sensitive negative-working reproduction layers, which optionally contain an organic binder and are based on water, an anionic surfactant, at least one inorganic salt showing alkaline reaction and at least one aliphatic dicarboxylic acid or a salt thereof, wherein said developer composition has a pH in the range of 8 to 12 and contains

a) 0.05 to 10 % by weight of a sodium, potassium or lithium salt of the sulfuric acid ester of a $C_7$ to $C_{14}$ alkanol ;

b) 0.001 to 5 % by weight of sodium, potassium or ammonium metasilicate ;

c) 0.1 to 15 % by weight of a sodium, potassium, lithium or ammonium borate ;

d) 0.01 to 5 % by weight of a $C_2$ to $C_6$ alkane diacid or of one of its sodium, potassium or ammonium salts ; and

e) 0.5 to 12 % by weight of a di- or trisodium phosphate or di- or tripotassium phosphate ;

and the weight ratio of sodium ions : potassium ions contained in the developer composition varies between 1 : 1 and 1.4 : 1.

2. Developer composition as claimed in claim 1, which contains a) a sodium salt of the sulfuric acid ester of an octanol or decanol ; b) sodium metasilicate ; c) potassium tetraborate ; d) potassium oxalate ; and e) di- or trisodium phosphate.

3. Process for developing negative-working reproduction layers, in which the irradiated radiation-sensitive reproduction layer, which optionally contains an organic binder is developed with an aqueous-alkaline developer composition based on water, an anionic surfactant, at least one inorganic salt showing alkaline reaction and at least one aliphatic dicarboxylic acid or a salt thereof, wherein said developer composition has a pH in the range of 8 to 12 and contains

a) 0.05 to 10 % by weight of a sodium, potassium or lithium salt of the sulfuric acid ester of a $C_7$ to $C_{14}$ alkanol ;

b) 0.001 to 5 % by weight of sodium, potassium or ammonium metasilicate ;

c) 0.1 to 15 % by weight of a sodium, potassium, lithium or ammonium borate ;

d) 0.01 to 5 % by weight of a $C_2$ to $C_6$ alkane diacid or of one of its sodium, potassium or ammonium salts ; and

e) 0.5 to 12 % by weight of a di- or trisodium phosphate or di- or tripotassium phosphate ;

and the weight ratio of sodium ions : potassium ions contained in the developer composition varies between 1 : 1 and 1.4 : 1.


## Revendications

1. Agent de développement alcalin-aqueux pour des couches de reproduction, exposées, photosensibles, travaillant en négatif et contenant éventuellement un liant organique, à base d'eau, d'un agent tensioactif anionique, d'au moins un sel minéral à réaction alcaline et d'au moins un acide dicarboxylique aliphatique ou d'un de ses sels, lequel agent est caractérisé en ce qu'à une valeur de pH de 8 à 12, il contient :

a) de 0,05 à 10 % en poids d'un sel de sodium, de potassium ou de lithium de l'ester sulfurique d'un alcanol en $C_7$ à $C_{14}$,

b) de 0,001 à 5 % en poids d'un métasilicate de sodium, de potassium ou d'ammonium,

c) de 0,1 à 15 % en poids d'un borate de sodium, de potassium, de lithium ou d'ammonium,

d) de 0,01 à 5 % en poids d'un diacide alcanoïque en $C_2$ à $C_6$ où d'un de ses sels de sodium, de potassium ou d'ammonium, et

e) de 0,5 à 12 % en poids d'un phosphate di- ou trisodique ou di- ou tripotassique, et en ce que le rapport pondéral des ions sodium aux ions potassium dans l'agent de développement est compris entre 1 : 1 et 1,4 : 1.

2. Agent de développement selon la revendication 1, caractérisé en ce que l'agent de développement contient a) un sel de sodium de l'ester sulfurique d'un octanol ou d'un décanol, b) du métasilicate de sodium, c) du tétraborate de potassium, d) de l'oxalate de potassium et e) un phosphate disodique ou trisodique.

3. Procédé pour le développement de couches de production travaillant en négatif, dans lequel la couche de reproduction exposée, contenant éventuellement un liant organique, est traitée avec un agent de développement alcalin-aqueux contenant de l'eau, un agent tensioactif anionique, au moins un sel minéral à réaction alcaline, et au moins un acide dicarboxylique aliphatique ou un de ses sels, lequel procédé est caractérisé en ce que l'agent de développement, à une valeur de pH de 8 à 12, contient :

a) de 0,05 à 10 % en poids d'un sel de sodium, de potassium ou de lithium de l'ester sulfurique d'un alcanol en $C_7$ à $C_{14}$,

b) de 0,001 à 5 % en poids d'un métasilicate de sodium, de potassium, de lithium ou d'ammonium,

c) de 0,1 à 15 % en poids d'un borate de sodium, de potassium, de lithium ou d'ammonium,

d) de 0,01 à 5 % en poids d'un diacide alcanoïque en $C_2$ à $C_6$ ou d'un de ses sels de sodium, de potassium ou d'ammonium, et

e) de 0,5 à 12 % en poids d'un phosphate di- ou trisodique ou di- ou tripotassique, et en ce que le rapport pondéral des ions sodium aux ions potassium dans l'agent de développement est compris entre 1 : 1 et 1,4 : 1.